**Europäisches Patentamt**

**European Patent Office**

**Office européen des brevets**

(19)

(11) Veröffentlichungsnummer: **0 348 839**

**A1**

(12) # EUROPÄISCHE PATENTANMELDUNG

(21) Anmeldenummer: **89111460.5**

(22) Anmeldetag: **23.06.89**

(51) Int. Cl.4: **G01R 31/36**

(30) Priorität: **28.06.88 DE 3821808**

(43) Veröffentlichungstag der Anmeldung:
**03.01.90 Patentblatt 90/01**

(84) Benannte Vertragsstaaten:
**ES GR**

(71) Anmelder: **Helmut Händel & Partner
Messdatentechniek KG Ringstrasse 6
D-8031 Eichenau(DE)**

(72) Erfinder: **Trescher, Peter
Ludwigshöher Strasse 21a
D-8000 München 71(DE)**

(74) Vertreter: **Patentanwälte Grünecker,
Kinkeldey, Stockmair & Partner
Maximilianstrasse 58
D-8000 München 22(DE)**

(54) Verfahren und Vorrichtung zum automatischen Testen eines wenigstens einen Einzelakkumulator aufweisenden Akkumulatorsystems einer unterbrechungsfreien Stromversorgungsanlage.

(57) Die Erfindung betrifft ein Verfahren und eine Vorrichtung zum automatischen Testen eines wenigstens einen Einzelakkumulator aufweisenden Akkumulatorensystems einer unterbrechungsfreien Stromversorgungsanlage. Die Erfindung überprüft und testet die einzelnen Akkumulatoren des Akkumulatorensystems, in dem zunächst einen Einzelakkumulator ein Zusatzakkumulator parallel geschaltet wird und dann der Einzelakkumulator aus dem Akkumulatorensystem herausgetrennt wird. Der Akkumulator kann dann getestet werden und im Falle einer Fehlfunktion ausgewechselt werden. Die Erfindung ermöglicht ein Auswechseln defekt erkannter Einzelakkumulatoren unter Aufrechterhaltung der Möglichkeit einer Notstromversorgung bei Ausfall des Versorgungsnetzes.

FIG.1

EP 0 348 839 A1

## Verfahren und Vorrichtung zum automatischen Testen eines wenigstens einen Einzelakkumulator aufveisenden Akkumulatorsystems einer unterbrechungsfreien Stromversorgungsanlage

Die Erfindung betrifft ein Verfahren und eine Vorrichtung zum automatischen Testen eines wenigstens einen Einzelakkumulator aufweisenden Akkumulatorsystems einer unterbrechungsfreien Stromversorgungsanlage.

Unterbrechungsfreie Stromversorgungsanlagen finden in immer größerem Maße in den unterschiedlichsten Anwendungsgebieten Verwendung. So werden derartige Stromversorgungsanlagen in allgemeinen als Notstromversorgungen in Raumschutz-, Brandmelde-, Alarmund sonstigen Anlagen, insbesondere auch Computeranlagen eingesetzt und unterliegen besonders hohen Zuverlässigkeitsanforderungen. Stromversorgungsanlagen arbeiten im allgemeinen so, daß bei Netzausfall des Stromversorgungsnetzes ein aus mehreren Einzelaklumulatoren bestehendes Akkumulatorsystem die Stromversorgung so lange übernimmt, bis über das Netz wieder Strom zur Verfügung steht. Bedingt durch die natürliche Alterung bei Akkumulatoren und dem damit verbundenen Kapazitätsschwund (auch bedingt durch unterschiedliche Belastungs- und Anwendungsarten) wird aber ein Akkumulatorsystem mit der Zeit "schwächer", d.h. die bei Netzausfall erreichbare Überbrückungszeit durch das Akkumulatorsystem wird mit zunehmendem Alter der Akkumulatoren immer kürzer. Krtisch wird dies dann, wenn einer oder mehrere Einzelakkumulatoren "unbemerkt taub" werden. Gerade dann, wenn die Akkumulatorsysteme selten oder nie gebraucht werden, ist die Gefahr einer unbemerkt gebliebenen Akkumulatorstörung eines oder mehrerer Einzelakkumulatoren in einem solchen Akkumulatorsystem besonders groß.

Es ergibt sich daher die Notwendigkeit, ein derartiges Akkumulatorsystem von Zeit zu Zeit auf Funktionstüchtigkeit zu überprüfen. Bisherige Verfahren messen die Spannung des gesamten Akkusystems oder prüfen den Ladestrom, den das Stysem aufnimmt. Wieder andere Systems messen den Ph-Wert der Akkumulatorenzelle. Bei Akkumulatorsystemen mit mehreren Einzelakkumulatoren hat dies den Nachteil, daß keine Aussage über den Zustand der Einzelakkumulatoren und deren Kapazität gewonnen werden kann. Eine zuverlässige Aussage über die Funktionsfähigkeit des Gesamtsystems ist daher nicht möglich, weil ein Einzelakkumulator in dem System der kurz vor Erreichen der Funktionsuntüchtigkeit steht, nicht erfaßt werden kann.

Aufgabe der Erfindung ist es, ein Verfahren und eine Vorrichtung zum automatischen Testen eines wenigstens einen Einzelakkumular aufweisenden Akkumulatorsystems für eine unterbrechungsfreie Stromversorgungsanlage vorzuschlagen, das bzw. die in der Lage ist, zuverlässig und rechtzeitig den bevorstehenden Ausfall eines Einzelakkumulators des Akkumulatorsystems anzuzeigen und wobei im Falle des Erkennens eines Defektes ein Austausch des defekten Einzelakkumulators unter Aufrechterhaltung der Notstromversorgung ermöglicht werden soll.

Das Verfahren, das erfindungsgemäß diese Aufgabe löst, ist durch die folgenden Schritt gekennzeichnet:

a) es wird zunächst einem ersten Einzelakkumulator des Akkumulatorsystems ein Zusatzakkumulator parallel geschaltet;

b) es wird dann dieser Einzelakkumulator aus dem Akkumulatorsystem herausgeschaltet, wobei der Zusatzakkumulator dann die Funktion dieses herausgetrennten Einzelakkumulators im Akkumulatorsystem übernimmt;

c) es wird dann der Funktionszustand des herausgetrennten Einzelakkumulators getestet;

d) es wird dann, wenn die Prüfung ergeben hat, daß der gerade getestete Einzelakkumulator funktionstüchtig ist, dieser Einzelakkumulator durch Parallelschaltung zum Zusatzakkumulator wieder in das Akkumulatorsystem eingeschaltet, daraufhin der Zusatzakkumulator herausgeschaltet und die Schritt a) bis d) für einen nächsten, zu testenden Akkumulator wiederholt und

e) es wird dann, wenn die Prüfung ergeben hat, daß der Einzelakkumulator funktionsuntüchtig ist, das Testverfahren abgebrochen, wobei der Zusatzakkumulator bis zum Auswechseln des defekten Einzelakkumulators dessen Funktion innehält.

Mit diesen Merkmalen wird es möglich, zum einen Kenntnis über den Funktionszustand eines einzelnen Einzelakkumulators in einem Akkumulatorsystem zu erhalten und trotzdem die volle Notstromversorgung im Falle eines Ausfalls der Netzspannung sicherzustellen. Dadurch, daß man zunächst dem Einzelakkumulator, dessen Funktion untersucht werden soll, einen Zusatzakkumulatoren parallel schaltet und erst dann den Einzelakkumulator aus dem Akkumulatorsystem herausschaltet, ist sichergestellt, daß das gesamte Akkumulatorsystem unterbrechungsfrei weiterarbeitet, obwohl ein Einzelakkumulator zu Testzwecken herausgeschaltet worden ist. Dann kann der Einzelakkumulator automatisch mit bekannten Verfahren auf seine Funktionsfähigkeit untersucht werden. Wenn diese Untersuchung ergaben hat, daß der Einzelakkumulator funktionsfähig ist, wird er wieder in das Akkumulatorsystem eingeschaltet, in dem er zum Zusatzakkumulator parallel geschaltet wird. Erst dann wird der Zusatzakkumulator abgeschaltet und dem nächsten, zu untersuchenden Einzelakkumulatoren parallel geschaltet. Dieses Verfahren wird zyklisch wiederholt bis sich ergibt, daß ein gerade getesteter Einzelakkumulator aufgrund der gemessenen Kennlinien funktionsunfähig ist, dann wird das Testverfahren unterbrochen. Der Zusatzakkumulator übernimmt dann bis zum Auswechseln des defekten Einzelakkumulators dessen Funktion. Bei diesem Verfahren kommt es nicht darauf an, wie die Einzelakkumulatoren zu einem Akkumulatorsystem zusammengeschaltet sind. Diese Einzelakkumulatoren können in beliebiger Weise zusammengeschaltet sein, also parallel- oder seriell oder auch in einer Mischverschaltung.

In einer bevorzugten Verfahrensführung ist vorgesehen, daß das automatische Testen zyklisch durchgeführt wird, indem bei einem Zyklus alle Einzelakkumulatoren des Akkumulatorsystems nacheinander gestestet werden und wobei zwischen jedem Testzyklus ein Teststillstand, dessen Dauer vorzugsweise einstellbar ist, vorgenommen wird. Das so durchgeführte Verfahren ermöglicht die automatische zyklische Überprüfung in bestimmten sinnvollen Zeitabständen, die einstellbar sind. Bei jedem Testzyklus werden alle Einzelakkumulatoren überprüft. Wenn allerdings in einem Zyklus ein Defekt bei einem Einzelakkumulator festgestellt wird, wird der Testzyklus unterbrochen. Der Zusatzakkumulator übernimmt dann die Funktion des defekten Einzelakkumulators. Die einstellbare Pause zwischen einzelnen Testzyklen kann in weiten Grenzen variabel sein. Sinnvollerweise beträgt sie minimal 3 Stunden, kann aber auch mehrere Tage betragen.

In einer weiteren sehr vorteilhaften Verfahrensführung ist vorgesehen, daß vor jedem Testzyklus der Zusatzakkumulator auf Funktiontüchtigkeit überprüft wird. Mit dieser Maßnahme wird sichergestellt, daß im Falle des Erkennens eines defekten Einzelakkumulators beim Test nicht an die Stelle des defekten Einzelakkumulators ein defekter Zusatzakkumulator geschaltet wird. Diese Überprüfung geschieht zyklisch automatisch vor Beginn jedes einzelnen Testzyklus.

Es ist zweckmäßig, daß bei Erkennen eines defekten Einzelakkumulators ein Alarmsignal abgegeben wird. Der Betreiber der Anlage hat dann die Möglichkeit, unmittelbar zu erkennen, daß ein Einzelakkumulator defekt ist. Das System kann dabei auch automatisch anzeigen, welcher der Einzelakkumulatoren in einem Akkumulatorsystem defekt ist. Ein Austausch läßt sich dann in einfacher Weise vornehmen.

In weiterer vorteilhafter Ausgestaltung des Verfahrens ist vorgesehen, daß zur Überprüfung des Zustandes eines herausgetrennten Einzelakkumulators und des Testakkumulators dieser Akkumulator mit einem definierten Strom über eine definierte Zeitspanne belastet wird und daß während dieser Zeit die Spannung ständig mit einem vorgewählten Sollwert verglichen wird (Lanzeitbelastung). Sinkt die Akkuspannung innerhalb der Meßzeit auf einen Wert unter den Sollwert ab, wird dann das Alarmsignal ausgelöst. Dieser Alarm kann dann z.B. an eine zentrale Erfassungsstelle weitergeleitet werden. Die definierte Zeitspanne soll dabei mindestens 2,5 Minuten betragen. Eine Belastung unterhalb dieser Zeitspanne erlaubt im allgemeinen keine zuverlässigen Rückschlüsse auf die Funktionsfähigkeit des zu testenden Akkumulators.

In einer weiteren vorteilhaften Ausgestaltung der Erfindung ist vorgesehen, daß bei einem an ein Versorgungsnetz angeschlossenen Akkumulatorsystems der Test nur durchgeführt wird, wenn kein Versorgungsausfall im Versorgungsnetz vorliegt. Im Falle eines Versorgungsnetzausfalles wird aus dem Akkumulatorsystem ein hoher Strom benötigt, da dieses Akkumulatorsystem dann für den Weiterbetrieb der angeschlossenen Anlage zuständig ist. Durch die eingegebene Maßnahme wird dann sichergestellt, daß kein Schaltvorgang im Akkumulatorsystem während dieser Zeit vorgenommen wird, um die elektrischen Umschalter vor Verschleiß zu sichern. Dies ist besonders wichtig, wenn der Netzausfall während des Testens eines der Einzelakkumulatoren auftritt. In diesem Falle wird die zum Testen vorgenommene Strombelastung abgeschaltet. Sobald das Versorgungsnetz wieder verfügbar ist, kann mit dem Testzyklus an der Stelle fortgefahren werden, an der der Testzyklus unterbrochen worden ist. Es kann aber auch vorgesehen sein, den Testzyklus abzubrechen.

Die erfindungsgemäße Vorrichtung, mit der dieses Verfahren durchgeführt werden kann, ist dadurch gekennzeichnet, daß sie einen Zusatzakku gleichen Typs wie die zu testenden Einzelakkumulatoren des Akkumulatorsystems aufweist, daß sie für jeden Einzelakkumulator des zu testenden Akkumulatorsystems zwei Schaltelemente aufweist, von denen eines bei Betätigung den Zusatzakkumulator den zu testenden Einzelakkumulator parallel schaltet oder die Parallelschaltung aufhebt und das andere bei Betätigung den Einzelakkumulator aus dem Akkumulatorsystem heraus-bzw. wieder hineinschaltet, daß sie eine Funktionszustandstestschaltung aufweist, über die ein jeweils aus dem Akkumulatorsystems herausgetrennter Einzelakkumulator auf seinen Funktionszustand getestet werden kann und daß die Vorrichtung eine Steuereinheit aufweist, die die Schaltelemente und die Funktionszustandstestschaltung entsprechend den im Anspruch 1 angegebenen Merkmalen a) bis e) steuert.

Eine solche Vorrichtung ist in der Lage, automatisch die Testzyklen gemäß den im Anspruch 1 angegebenen Verfahrensschritten durchzuführen. Durch die beiden Schaltelemente, die jeweils einen Einzelakkumulator vorgesehen sind, ist es möglich, jeden Einzelakkumulator des Akkumulatorsystems zunächst parallel zu dem Zusatzakkumulator zu schalten und dann aus dem Akkumulatorsystem heraus zu trennen. Dann kann dieser herausgetrennte Einzelakkumulator wie beschrieben getestet werden und im Falle eines positiven Testergebnisses (Funktionstüchtigkeit) wieder in das Akkusystem eingeschaltet werden.

In sehr vorteilhafter Weiterbildung der Vorrichtung ist vorgesehen, daß sie einen Stromdetektor aufweist, der so geschaltet ist, daß er die Richtungen und die Stärke des in das Akkumulatorsystem fließenden Stromes erfaßt.

Dieser Detektor kann an der Richtung des in das Akkumulatorsystem fließenden Stromes feststellen, ob das Versorgungsnetz intakt ist. Fließt der Strom in das Akkumulatorsystem, so ist das Versorgungsnetz vorhanden, dreht sich die Stromrichtung um, so wird ein Versorgungsnetzausfall erkannt und entsprechend dann an die Steuereinheit weitergegeben, die dann die Testzyklen wie oben erwähnt unterbricht. Fließt kein Strom, so wird ein Defekt im Ladegerät der zu überwachenden Anlage erkannt.

Durch diesen Stromdetektor im Verbund mit der Steuereinheit ist es möglich, daß für den Betrieb der Vorrichtung kein Eingriff in das zu überwachende Gerät notwendig ist. Es ist weiterhin zur Erkennung eines Versorgungsnetzausfalls nicht notwendig, daß die zu überwachende Anlage und die Vorrichtung an denselben Versorgungsnetz angeschlossen sein müssen.

In weiterer Ausgestaltung der erfindungsgemäßen Vorrichtung ist vorgesehen, daß die Steuereinheit einen manuell betätigkbaren Auslöser aufweist, über den manuell zwischen zwei automatisch ablaufenden Prüfzyklen ein zusätzlicher Prüfzyklus gestattet werden kann. Diese manuelle Betätigung erlaubt es dem Wartungspersonal, die Überprüfung der Steuerung zu ermöglichen. Die Begrenzung auf nur einen zusätzlichen Prüfzyklus ist deshalb vorteilhaft, weil dadurch verhindert wird, daß die Einzelakkumulatoren durch dauernde Testzyklen unnötig belastet und zu einem Akkumulatorenalarm führen, obwohl ansich das Akkumulatorsystems fehlerfrei arbeiten würde.

In einer weiteren Ausgestaltung der Erfindung ist vorgesehen, daß die Vorrichtung mit einer eigenen internen Stromversorgung versehen ist. Wenn die Netzversorgung ausfällt, wird das Gerät über den Zusatzakkumulator versorgt, der seinerseits wieder von der Vorrichtung wie erwähnt selbst laufend überwacht wird.

Eine vorteilhafte Ausgestaltung der Erfindung sieht vor, daß die Schaltelemente als Schaltrelais ausgebildet sind. Es können aber auch andere elektrische oder elektromagnetische Schaltelemente, beispielsweise auch Tyristor- und/oder Transistorschaltelemente eingesetzt werden. Diese Schaltelemente werden durch die Steuerung überwacht - müssen überwacht werden -, um eine Fehlfunktion des Systems zu vemeiden, die im ungünstigen Fall die Unterbrechungsfreiheit des Akkumulatorsyystems nicht mehr gewährleisten würde. Das System löst einen Alarm aus und stoppt seine weiteren Aktivitäten, bevor es zu einer Fehlfunktion kommt.

In einer weiteren vorteilhaften Ausgestaltung der Erfindung ist vorgesehen, daß die Steuerschaltung eine Alarmeinheit aufweist, die bei Erkennen eines defekten Einzelakkumulators ein Alarmsignal abgibt. Dieses Alarmsignal kann optisch, akkustisch oder in anderer Weise gegeben werden.

In weiterer Ausgestaltung der Erfindung ist vorgesehen, daß die Steuerschaltung eine Quittiertaste aufweist, mit der nach Austauschen eines als defekt erkannten Einzelakkumulators die Fortführung eines Prüfzyklus oder das Zurücksetzen der Vorrichtung in die Grundstellung veranlaßt werden kann.

Schließlich sieht die Erfindung vor, daß die Steuerschaltung einen Zeitgeber aufweist, über den der Zeitabstand zwischen zwei aufeinanderfolgenden Testzyklen variabel vorgegeben werden kann. Diese Maßnahme ist sinnvoll, weil dann die Vorrichtung an die unterschiedlichsten Anforderungen angepaßt werden kann.

Die Erfindung wird im folgenden anhand des in der Zeichnung dargestellten Ausführungsbeispieles weiter erläutert und beschrieben:

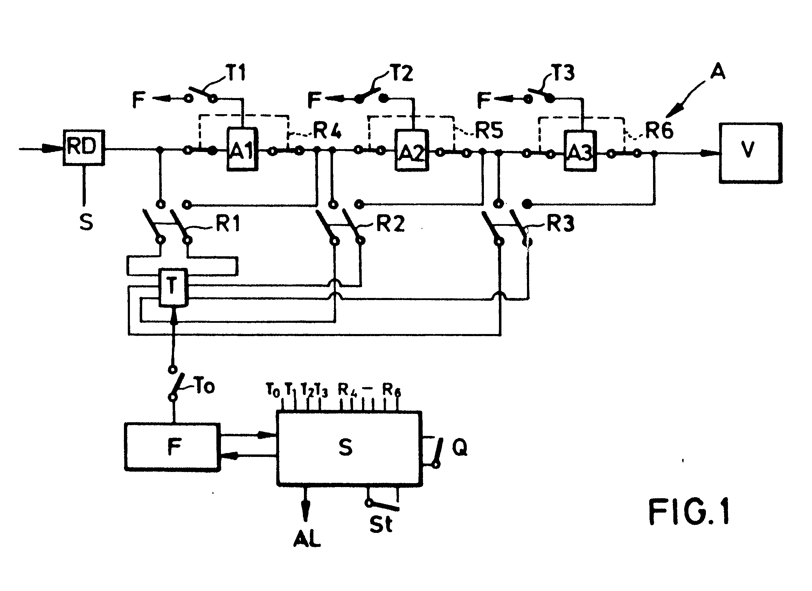

Dabei zeigt die Figur 1 eine schematische Schaltskizze einer erfindungsgemäßen Vorrichtung, mit der das erfindungsgemäße Verfahren ausgeführt werden kann. In Figur 1 ist die Vorrichtung im Grundzustand.

Figur 2 zeigt die erste Stufe eines eingeleiteten Testszyklus,

Figur 3 zeigt die nächste Stufe des Testzyklus,

Figur 4 zeigt eine weitere Stufe des Testzyklus der Vorrichtung.

In Figur 1 ist eine erfindungsgemäße Vorrichtung schematisch in einer Schaltskizze dargestellt. Es sind nur die wesentlichen Elemente der Vorrichtung gezeigt. Die dargestellte Vorrichtung läßt ein Akkumulatorsystem erkennen, das aus den einzelen Akkumulatoren A1, A2, A3 gebildet wird. Das erfindungsgemäße Verfahren kann auch bei einem Akkumulatorsystem mit nur einem einzigen Einzelakkumulator durchgeführt werden. In der Praxis wird es aber bevorzugt bei Akkumulatorsystemen eingesetzt, die eine größere Anzahl von Einzelakkumulatoren aufweisen. Im Ausführungsbeispiel sind 3 solche Einzelakkumulatoren gezeigt, was völlig ausreicht, um die prinzipielle Funktionsweise der Erfindung zu erläutern. Das Akkumulatorsystem A ist Teil einer nicht näher gezeigten unterbrechtungsfreien Stromversorgungsanlage für einen Verbraucher V und ist in bekannter Weise so geschaltet, daß es in der Lage ist, bei einem Netzausfall die Versorgung des Verbrauchers V zu übernehmen. In dem gezeigten Ausführungsbeispiel sind die Einzelakkumulatoren A1, A2, A3 in Reihe hintereinandergeschaltet. Die Erfindung ist jedoch gleichermaßen auch bei parallel geschalteten oder mischverschalteten Einzelakkumulatoren anwendbar.

Den Einzelakkumulatoren A1, A2, A3 sind nun erfindungsgemäß jeweils 2 Schaltelemente zugeordnet. So ist dem Einzelakkumulator A1 das Relais R1 und das Relais R4 zugeordnet, dem Einzelakkumulator A2 das Relais R2 und R5 und dem Einzelakkumulator A3 das Relais R3 und R6. Die Relais R1, R2 und R3 dienen jeweils dazu, die zugeordneten Einzelakkumulatoren an einen Zusatzakkumulator T anzuschließen. Der Zusatzakkumulator T ist vom selben Typ wie die Einzelakkumulatoren A1, A2, A3. Die Relais R4, R5 und R6 erlauben es, bei Betätigung den jeweils zugeordneten Einzelakkumulator aus der Reihenschaltung des Akkumulatorsystems A herauszutrennen.

An den Zusatzakkumulator T und an die Einzelakkumulatoren A1, A2 und A3 kann über die Schalter T0 bzw. T1, T2 und T3 eine Funktionszustandsschaltung F angeschlossen werden.

Die Vorrichtung wird mittels der Steuereinheit S betrieben, die mit nicht näher gezeigten Taktgebern und einer elektronischen Schaltung ausgestattet ist, um die angegebenen, im folgenden näher erläuterten Abläufe zu steuern.

In der Figur 1 findet sich die Schaltung im Grundzustand. Die Relais R4, R5, R6 schalten die Einzelakkumulatoren A1, A2, A3 in Reihe hintereinander. Der Zusatzakkumulator T ist vom System abgekoppelt.

In festen, an der Steuereinheit einstellbaren Zeitabständen, die zwischen wenigen Stunden und mehreren Tagen eingestellt werden können, startet nun die Steuereinheit einen Testzyklus, dessen Aufgabe es ist, den Funktionszustand der Einzelakkumulatoren A1, A2 und A3 automatisch zu testen. Bei diesem Ausführungsbeispiel wird vor Beginn des Tests der Einzelakkumulatoren A1, A2, A3 der Zusatzakkumulator T getestet. Hierzu schließt die Steuereinheit S den Zusatzakkumulator T unter Betätigung des Schalters T0 an die Funktionszustandsschaltung S an. Bei Anschluß sowohl des Testakkumulator T als auch der Einzelakkumulatoren A1, A2, A3 belastet die Funktionszustandsschaltung F den jeweils angeschlossenen Akkumulator mit einem definierten Strom über eine definierte Zeit (Langzeitbelastung), die wenigstens 2,5 Minuten betragen sollte. Während dieses Zeitraums wird die Spannung ständig mit einem eingestellten Sollwert verglichen. Dieser Sollwert ist auf der in der Steuereinheit bzw. in der Funktionszustandsschaltung abgespeicherten Akkumulatorentladungskennlinie so angeordnet, daß der Akkumulator an jeder Stelle oberhalb dieses Arbeitspunktes noch die gewünschte Mindestnotlaufkapazität besitzt oder das Mehfache. Eine solche Kennlinie kann für jeden Akkumulatorentyp in der Funktionszustandsschaltung abgespeichert sein. Wenn die Akkumulatorspannung des angeschlossenen Akkumulators diesen Sollwert unterschreitet, so bedeutet dies, daß der Akkumulator nicht mehr die Mindestnotaufkapazität besitzt oder das Mehrfache und daher als defekt erkannt werden muß mit der Folge, daß ein entsprechendes Alarmsignal Al von der Steuereinheit ausgegeben wird.

Wenn nun die Funktionszustandschaltung zu Beginn eines Testzyklus erkennt, daß der Zusatzakkumulator T0 nicht die Mindestnotlaufkapazität oder das Mehrfache besitzt, wird bereits an dieser Stelle ein Alarmsignal ausgegeben und der Testzyklus nicht weiter fortgesetzt.

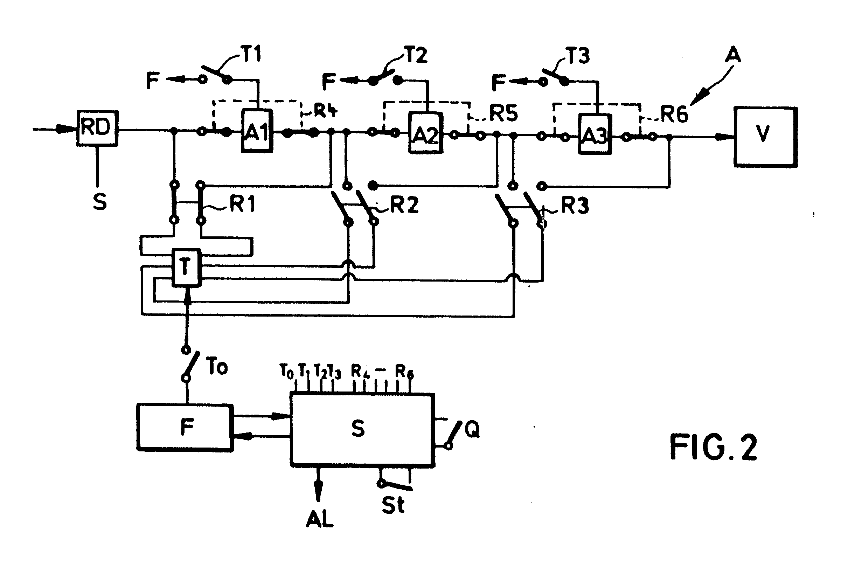

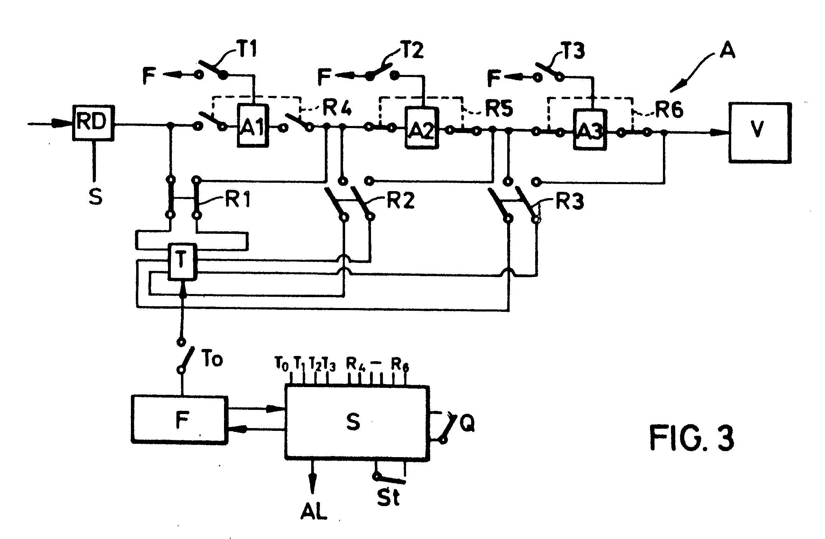

Wenn jedoch erkannt wird, daß der Funktionszustand des Akkumulators T in Ordnung ist, beginnt der eigentliche Test der Einzelakkumulatoren A1 bis A3. Hierzu wird zunächst der Zusatzakkumulator T durch öffnen des Schalters T0 wieder von der Funktionszustandsschaltung abgetrennt. Als nächstes wird das Relais R1 betätigt. Das Relais R4 ist zu diesem Zeitpunkt noch geschlossen. Es liegt, wie das der Schaltzustand in Figur 2 zeigt, der Zusatzakkumulator T parallel zu dem Einzelakkumulator A1 Nun wird in einem nächsten Schritt das Relais R4 geöffnet. Damit ist der Einzelakkumulator A1 aus der Reihenschaltung des Akkumulatorsystems A herausgetrennt, durch die zuvor erfolgte Parallelschaltung des Zusatzakkumulators T kann die Funktion des Einzelakkumulators A1 von dem Testakkumulator T übernommen werden, so daß das Akkumulatorsystem A voll funktionsfähig bleibt. Der Zustand der herausgetrennten Einzelakkumulators A1 ist in der Figur 3 gezeigt.

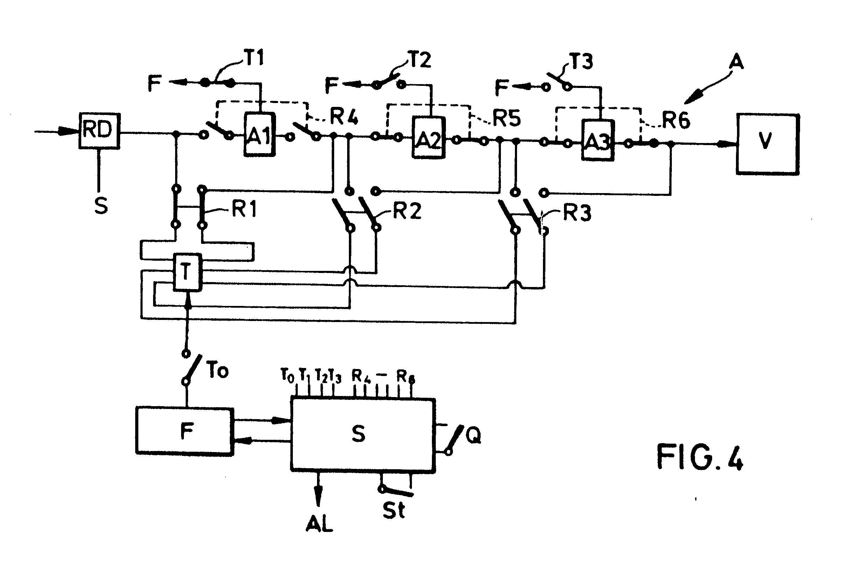

Nun wird, wie Figur 4 zeigt, in einem nächsten Schritt der herausgetrennte Einzelakkumulator A1 durch Betätigung des Schalters T1 an die Funktionszustandsschaltung F angeschlossen. Diese Schaltung führt nun die Zustandsüberprüfung in der oben bereits beschriebenen Art und Weise durch. Ergibt das Ergebnis, daß der Einzelakkumulator A1 nicht mehr die gewünschte Mindestnotlaufkapazität oder das Mehrfache aufweist, so gibt die Steuereinheit S das Alarmsignal Al aus. Der Zusatzakkumulator T bleibt so lange in Reihenschaltung mit den übrigen Einzelakkumulatoren A2, A3 des Akkumulatorsystems A bis der defekte Einzelakkumulator A1 ausgetauscht worden ist. Der Austausch kann über eine Quittiertaste Q in das System eingegeben werden.

Dann kann der Testzyklus fortgesetzt werden. Der Testzyklus wird selbstverständlich auch dann fortgesetzt, wenn der Test des Einzelakkumulators A1 ergibt, daß dieser Akkumulator im Hinblick auf die gestellten Anforderungen in Ordnung ist. Nun wird in weiteren Schritten, deren breiten Erläuterung es hier nicht mehr bedarf, der Schalter T1 wieder geöffnet, das Relais R4 wieder geschlossen und das Relais R1 wieder geöffnet. Der Testzyklus wird nun fortgesetzt, wobei als nächstes der als Einzelakkumulator A2 getestet wird. Hierzu wird dann wieder entsprechend das Relais R2 geschlossen, das Relais R5 geöffnet, der Schalter T2 geschlossen, so daß dann der Einzelakkumulator A2 getestet wird. Dieses Verfahren wird nun für alle Einzelakkumulatoren fortgesetzt, so lange bis sämtliche Einzelakkumulatoren des Akkumulatorsystems A getestet worden sind. Dann kehrt das System wieder zurück in den in Figur 1 gezeigten Grundzustand. Nach Ablauf der eingestellten Zeit für den Testzyklenabstand wird das Verfahren dann wieder automatisch wiederholt.

Da im Falle eines Versorgungsnetzausfalls ein hoher Strom aus dem Akkumulatorsystems entnommen werden muß, um den Verbraucher F zu versorgen, ist es günstig, in diesem Falle keinen Testzyklus durchzuführen, weil dann die einzelnen Akkumulatoren zusätzlich belastet werden würden. Aus diesem Grund ist die Vorichtung mit einem Stromrichtungsdetektor RD ausgestattet, der die Richtung und die Höhe des in das Akkumulatorsystem fließenden Stroms erfaßt. Der Richtungsdetektor RD ist ebenfalls an die Steuereinheit S angeschlossen, so daß die Steuereinheit S sofort einen eventuellen Netzausfall erkennen kann. In diesem Falle schaltet die Steuereinheit S sofort einen eventuell gerade laufenden Prüfzyklus ab. Wenn kein Prüfzyklus läuft, verhindert die Steuereinheit, daß ein Prüfzyklus gestartet wird, so lange bis über den Richtungsdetektor erkannt wird, daß die Versorgungsnetzspannung wieder vorhanden ist.

Da der Richtungsdetektor RD die Richtung und die Stärke des in das Akkumulatorsystem fließenden Stromes detektiert, ist es nicht erforderlich, einen Eingriff in das zu überwachende Gerät vorzunehmen. Es ist außerdem auch nicht erforderlich, daß die dargestellte Vorrichtung an dasselbe Versorgungsnetz wie die zu überwachende Anlage V angeschlossen wird. Vielmehr wird bevorzugt, die Vorrichtung über eine eigene, nicht dargestellte interne Stromversorgung gespeist und so geschaltet ist, daß das Gerät über den Zusatzakkumulator T versorgt werden kann, der wie oben beschrieben von der Vorrichtung selbst laufend überwacht wird.

Um es dem Bedienungs- und Wartungspersonal zu ermöglichen, die Funktionsfähigkeit der gesamten Schaltung zu testen, ist ein zusätzlicher manueller Startknopf ST vorhanden, mit dem ein Prüf- bzw. Testzyklus manuell ausgelöst werden kann. Es sind jedoch in der Steuereinheit Vorkehrungen getroffen, die es verhindern, daß mehr als ein solcher Prüfzyklus zwischen zwei automatisch ablaufenden Prüfzyklen ausgelöst werden kann. Dies stellt sicher, daß die einzelnen Akkumulatoren nicht unnötig durch Tests belastet werden.

Aus dieser Beschreibung ergibt sich, daß mit diesem Verfahren und mit der Vorrichtung zur Durchführung des Verfahrens bedeutende Vorteile für die Wartung und des Testens von unterbrechungsfreien Stromversorgungsanlagen möglich sind. Die Überprüfung der einzelnen Akkumulatoren des Akkumulatorsystems findet zyklisch automatisch und unterbrechungsfrei statt. Während sämtlicher Testzyklen ist die Notstromversorgung garantiert. Die Notstromversorgung ist sogar dann garantiert, wenn die Schaltung feststellt, daß einer der Einzelakkumulatoren nicht mehr die geforderte Mindestnotlaufkapazität oder das Mehrfache aufweist. Für den Austausch dieses Einzelakkumulators ist ebenfalls keine Unterbrechung erforderlich, vielmehr wird über die gesamte Zeit trotz Wartung und Test die Notstromversorgung garantiert.

Die Schaltung kann konkret in vielerlei Variationen ausgeführt werden. So ist es nicht erforderlich, daß die einzelnen Schaltelemente Relais sind. Es sind hierfür auch Tyristor -und/oder Transistorschaltelemente eingesetzt werden. Die Ablaufsteuerung kann über eine elektronische Schaltung erreicht werden. Weitere Ausgestaltungen, die hier nicht gezeichnet sind, sind ebenfalls möglich. So können z.B. Lampen an der Vorichtung vorhanden sein, die anzeigen, welcher der einzelnen Akkumulatoren gerade geprüft wird.

**Ansprüche**

1. Verfahren zum automatischen Testen eines wenigstens einen Einzelakkumulator aufweisenden Akkumulatorensystems einer unterbrechungsfreien Stromversorgungsanlage, gekennzeichnet durch die folgenden Schritte

a) es wird zunächst einem Einzelakkumulator des Akkumulatorensystems ein Zusatzakkumulator parallel geschaltet;

b) es wird dann dieser Einzelakkumulator aus dem Akkumulatorensystem herausgetrennt, wobei der Zusatzakkumulator dann die Funktion dieses herausgetrennten Einzelakkumulators im Akkumulatorensystem übernimmt;

c) es wird dann der Funktionszustand des herausgetrennten Einzelakkumulators getestet;

d) es wird dann, wenn die Prüfung ergeben hat, daß der gerade getestete Einzelakkumulator funktionstüchtig ist, dieser Einzelakkumulator durch Parallelschaltung zum Zusatzakkumulator wieder in das Akkumulatorensystem eingeschaltet, daraufhin der Zusatzakkumulator herausgeschaltet und die Schritte a) bis d) für einen nächsten, zu testenden Einzelakkumulators wiederholt und

d) es wird dann, wenn die Prüfung ergeben hat, daß der Einzelakkumulator funktionsuntüchtig ist, das Testverfahren abgebrochen, wobei der Testakkumulator bis zum Auswechseln des defekten Einzelakkumulators dessen Funktion innehält.

2. Verfahren nach Anspruch 1,
**dadurch gekennzeichnet,**
daß das automatische Testen zyklisch durchgeführt wird, indem bei einem Zyklus alle Einzelakkumulatoren des Akkumulatorensystems getestet werden und wobei zwischen jedem Testzyklus ein Teststillstand, dessen Dauer vorzugsweise einstellbar ist, vorgenommen wird.

3. Verfahren nach Anspruch 1 oder 2,
**dadurch gekennzeichnet,**
daß zu Beginn eines jeden Testzyklus der Funktionszustand des Zusatzakkumulators getestet wird.

4. Vorrichtung nach wenigstens einem der vorangegangenen Ansprüche,
**dadurch gekennzeichnet,**
daß bei Erkennen eines defekten Einzelakkumulators oder des defekten Testakkumulators ein Alarmsignal abgegeben wird.

5. Vorrichtung nach wenigstens einem der vorangegangenen Ansprüche,
**dadurch gekennzeichnet,**
daß zur Überprüfung des Zustandes eines herausgetrennten Einzelakkumulators und des Zusatzakkumulators dieser Akkumulator mit einem definierten Strom über eine definierte Zeitspanne belastet wird (Langzeitbelastung) und daß während dieser Zeit die Spannung ständig mit einem vorgewählten Sollwert verglichen wird.

6. Vorrichtung nach Anspruch 5,
**dadurch gekennzeichnet,**
daß die definierte Zeitspanne mindestens 2,5 Minuten beträgt.

7. Verfahren nach wenigstens einem der vorangegangenen Ansprüche,
**dadurch gekennzeichnet,**
daß die Testzyklen nur dann durchgeführt werden, wenn kein Versorgungsnetzausfall im Versorgungsnetz des zu versorgenden Verbrauchers vorliegt.

8. Vorrichtung zum Testen einer wenigstens einen Einzelakkumulator aufweisenden Akkumulatorensystems einer unterbrechungsfreien Stromversorgungsanlage,
**dadurch gekennzeichnet,**
daß die Vorrichtung einen Zusatzakkumulator (T) gleichen Typs wie die zu testenden Einzelakkumulatoren (A1, A2, A3) des Akkumulatorensystems (A) aufweist,

daß die Vorrichtung für jeden Einzelakkumulator (A1, A2, A3) des zu testenden Akkumulatorensystems (a) zwei Schaltelemente (R1, R4; R2, R5; R3, R6) aufweist, von denen eines (R1, R2, R3) bei Betätigung den Zusatzakkumulator (T) dem zu testenden Einzelakkumulator (A1, A2, A3) parallel schaltet oder die Parallelschaltung aufhebt und das andere (R4, R5, R6) bei Betätigung den Einzelakkumulator (A1, A2, A3) aus dem Akkumulatorensystem heraus- bzw. wieder hineinschaltet,

daß die Vorrichtung eine Funktionszustandsschaltung (F) aufweist, über die ein jeweils aus dem Akkumulatorensystem (A) herausgetrennter Einzelakkumulator (A1, A2, A3) auf seinen Funktionszustand getestet werden kann und daß die Vorichtung eine Steuereinheit (F) aufweist, die die Schaltelemente (R1, R2, R3, R4, R5, R6; T0, T1, T2, T3) und die Funktionszustandsschaltung (F) so schaltet, daß einem der Einzelakkumulatoren (A1) des Akkumulatorensystems (A) der Zusatzakkumulator (T) parallel geschaltet wird, dann dieser Einzelakkumulator (A1) aus dem Akkumulatorensystem (A) herausgeschaltet wird, wobei der Zusatzakkumulator (T) dann die Funktion dieses herausgetrennten Akkumulators (A1) im Akkumulatorensystem übernimmt, und dann den herausgetrennten Einzelakkumulator (A1) an die Funktionszustandsschaltung (F) zur Überprüfung des Funktionszustandes anschließt und dann wenn die Prüfung ergeben hat, daß der gerade getestete Einzelakkumulator (A1) funktionstüchtig ist, diesen Einzelakkumulator durch Parallelschaltung zum Zusatzakkumulator (T) wieder in das Akkumulatorensystem einschaltet, daraufhin den Zusatzakkumulator herausschaltet und entsprechend so für weitere Einzelakkumulatoren verfährt, wobei die Steuerschaltung den Zusatzakkumulator dann, wenn die Prüfung ergeben hat, daß der herausgetrennte Einzelakkumulator funktionsuntüchtig ist, bis zum Auswechseln des defekten Einzelakkumulators zum Ersatz des herausgetrennten Einzelakkumulators (A) in das Akkumulatorensystem (A) eingeschaltet hält.

9. Vorrichtung nach Anspruch 8,
**dadurch gekennzeichnet,**
daß die Vorrichtung einen Stromdetektor (RD) aufweist, der so geschaltet ist, daß er die Richtung und die Stärke des in das Akkumulatorensystem (A) fließenden Stromes erfaßt.

10. Vorrichtung nach Anspruch 8 oder 9,
**dadurch gekennzeichnet,**
daß die Steuereinheit (S) einen manuell betätigkbaren Auslöser (ST) aufweist, über den manuell zwischen zwei automatisch ablaufenden Testzyklen ein zusätzlicher Testzyklus gestattet werden kann.

11. Vorrichtung nach wenigstens einem der Ansprüche 8 bis 10,
**dadurch gekennzeichnet,**

daß die Vorrichtung mit einer eigenen internen Stromversorgung versehen ist.

12. Vorrichtung nach wenigstens einem der Ansprüche 8 bis 11,

**dadurch gekennzeichnet,**

daß die Schaltelemente (R1 bis R6) als Schaltrelais ausgebildet sind.

13. Vorrichtung nach wenigstens einem der Ansprüche 8 bis 12,

**dadurch gekennzeichnet,**

daß die Steuerschaltung (S) eine Alarmeinrichtung (Al) aufweist, die bei Erkennen eines defekten Einzelakkumulators (A1, A2, A3) oder eines Defektes beim Zusatzakkumulators (T) ein Alarmsignal (Al) abgibt.

14. Vorrichtung nach wenigstens einem der Ansprüche 8 bis 13,

**dadurch gekennzeichnet,**

daß die Steuerschaltung eine Quittiertaste (Q) aufweist, mit der nach dem Austauschen eines als defekt erkannten Einzelakkumulators (A1, A2, A3) die Fortführung eines Prüfzyklus oder das Zurücksetzen in die Grundstellung (Figur 1) veranlaßt werden kann.

15. Vorrichtung nach wenigstens einem der Ansprüche 8 bis 14,

**dadurch gekennzeichnet,**

daß die Steuerschaltung (S) einen Zeitgeber aufweist, über den der Zeitabstand zwischen zwei aufeinanderfolgenden Testzyklen variabel vorgegeben werden kann.

16. Vorrichtung nach wenigstens einem der Ansprüche 8 bis 15,

**dadurch gekennzeichnet,**

daß die Steuerschaltung eine Überwachschaltung enthält, die die Schaltelemente überwacht und eine Fehlfunktion ausschließt und einen Alarm gibt, bevor die Fehlfunktion das System und die unterbrechungsfreie Arbeitsweise zum Verbraucher V gefährdet.

FIG.1

FIG.2

EP 0 348 839 A1

FIG. 3

EP 0 348 839 A1

FIG.4

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (Int. Cl.5) |
|---|---|---|---|
| A | DE-A-2 617 625 (THEO BENNING ELEKTROGERÄTE KG) <br> * Seite 4, Zeile 28 - Seite 5, Zeile 21 * <br><br> --- | 1,5,8, 12 | G 01 R 31/36 |
| A | REVIEW OF THE ELECTRICAL COMMUNICATIONS LABORATORIES, Band 34, Nr. 1, 1986, Seiten 105-109, The Research and Development Headquarters Nippon Telegraph and Telephone Corp.; M. ICHIMURA et al.: "A new capacity testing method for stationary batteries" <br> * Seite 105; Figur 1B * <br> --- | 1,5,6,8 | |
| A | US-A-4 451 791 (S.S. OSTROFF et al.) <br> * Spalte 1, Zeilen 30-37; Spalte 2, Zeilen 62-67 * <br> --- | 1,2,4, 13 | |
| A | US-A-4 021 718 (C.E. KONRAD) <br> * Spalte 3, Zeilen 32-39 * <br> --- | 9 | |
| A | EP-A-0 216 662 (J. ABIVEN et al.) <br> * Seite 4, Zeile 31 - Seite 5, Zeile 2 * <br><br> --- | 11 | **RECHERCHIERTE SACHGEBIETE (Int. Cl.5)** <br><br> G 01 R |
| A | EP-A-0 204 163 (ACCUMULATORENFABRIK SONNENSCHEIN GmbH) <br> * Anspruch 5 * <br> ------ | 15 | |

Der vorliegende Recherchenbericht wurde für alle Patentansprüche erstellt

| Recherchenort | Abschlußdatum der Recherche | Prüfer |
|---|---|---|
| DEN HAAG | 02-10-1989 | LUT K. |